# EUROPÄISCHE PATENTSCHRIFT

(11) **EP 3 784 012 B1**
(45) Veröffentlichungstag und Bekanntmachung des Hinweises auf die Patenterteilung: **04.10.2023**
(21) Anmeldenummer: 20192089.9
(22) Anmeldetag: 21.08.2020
(51) Int. Cl.: H05K 7/20

(54) **LEISTUNGSELEKTRONIK FÜR EIN FLURFÖRDERZEUG**
POWER ELECTRONICS FOR AN INDUSTRIAL TRUCK
ÉLECTRONIQUE DE PUISSANCE POUR UN CHARIOT DE MANUTENTION

(30) Priorität: 22.08.2019 DE 102019122660
(43) Veröffentlichungstag der Anmeldung: 24.02.2021
(73) Patentinhaber: Jungheinrich Aktiengesellschaft, 22047 Hamburg (DE)
(72) Erfinder: Petersen, Marinus, 24536 Neumünster (DE); Wetegrove, Ralf, 22850 Norderstedt (DE); Warncke, Matthias, 21073 Hamburg (DE)
(74) Vertreter: Hauck Patentanwaltspartnerschaft mbB

(56) Entgegenhaltungen:
- DE-B3-102017 201 410

## Beschreibung

Die vorliegende Erfindung betrifft eine Leistungselektronik für ein Flurförderzeug umfassend einen Kühlkörper und eine auf dem Kühlkörper angeordnete Leiterplatte mit Leistungshalbeitern. Es kann sich insbesondere um eine Leistungselektronik insbesondere für ein Einbauladegerät des Flurförderzeugs handeln.

Bei der Auslegung einer solchen Leistungselektronik sind zum einen der begrenzte Bauraum im Fahrzeug und zum anderen die meist recht große Wärmeentwicklung eine Herausforderung. Gerade bei im Flurförderzeug verbauten Ladegeräten entwickelt die Leistungselektronik aufgrund der hohen Leistungsdichte eine nicht unwesentliche abzuführende Wärmemenge, was einen großen Kühlkörper erfordert. Zugleich soll die Leistungselektronik aber möglichst klein bauen, um nicht zu viel des begrenzten Bauraums einzunehmen.

Zur Abfuhr der in den Kühlkörper aufgenommenen Wärme werden üblicherweise Axiallüfter verwendet, die einen Luftstrom in den Kühlkörper leiten. Die durch den Luftstrom transportierte Luftmenge, und damit die Kühlleistung, steigt dabei mit dem Durchmesser des Lüfters. Es ist demnach sinnvoll, einen möglichst großen Lüfter zu verwenden. Dies steht jedoch im Konflikt zu dem Ziel, das Bauvolumen der Leistungselektronik möglichst gering zu halten. Gerade bei der für eine derartige Leistungselektronik üblichen Anordnung des Lüfters seitlich am Kühlkörper lässt sich mit einem Axiallüfter eine ausreichende und effiziente Kühlung nur dann erreichen, wenn der Kühlkörper mindestens so hoch baut wie der Lüfter.

Aus DE 10 2017 201 410 B3 ist eine Kühlvorrichtung für eine Robotersteuerung bekannt. Die Kühlvorrichtung besitzt zwei flach auf dem Kühlkörper angeordnete Radiallüfter, deren ausströmende Luft über Kühlrippenvorsprünge entlang einer Kühlkörperwand zu einem Luftaustritt geleitet wird.

Ausgehend von dieser Problematik liegt der Erfindung die Aufgabe zugrunde, eine Leistungselektronik für ein Flurförderzeug bereitzustellen, die bei geringem Bauvolumen ausreichend gekühlt werden kann.

Erfindungsgemäß wird die Aufgabe durch eine Leistungselektronik mit den Merkmalen des Anspruchs 1 gelöst. Vorteilhafte Ausgestaltungen sind Gegenstand der Unteransprüche, der Beschreibung sowie der Figuren.

Erfindungsgemäß umfasst die Leistungselektronik der eingangs genannten Art einen Radiallüfter zur aktiven Kühlung des Kühlkörpers, wobei der Radiallüfter dazu ausgebildet ist, in einer axialen Richtung Luft anzusaugen und diese radial auszustoßen, und ein radial an den Radiallüfter anschließendes Umlenkelement zur Umlenkung zumindest eines Teils des von dem Radiallüfter radial ausgestoßenen Luftstroms in die axiale Richtung in den Kühlkörper hinein.

Die erfindungsgemäße Leistungselektronik ist für ein Flurförderzeug vorgesehen, kann insbesondere Teil eines Einbauladegeräts des Flurförderzeugs sein. Leistungselektronische Bauteile sind dabei als Leistungshalbeiter auf der Leiterplatte angeordnet. Beispielsweise können die Leistungshalbleiter durch Transistoren gebildet sein. Die Leistungshalbleiter können räumlich voneinander getrennt auf der Leiterplatte angeordnet sein oder auch in einem gemeinsamen Chip. Die Leistungshalbeiter können insbesondere auf die Leiterplatte aufgelötet sein. Die Leiterplatte steht mit dem Kühlkörper derart in wärmeleitendem Kontakt, dass durch den Betrieb der Leistungshalbeiter entstehende Wärme in den Kühlkörper abgeleitet wird. Die Leiterplatte kann insbesondere im Sinne eines top-cooling mit ihrer die Leistungshalbeiter aufweisenden Oberseite in Kontakt zu dem Kühlkörper stehen. Die Leiterplatte kann an dem Kühlkörper über Befestigungsmittel, insbesondere Schrauben, und bevorzugt mit Abstandshaltern zwischen Kühlkörper und Leiterplatte befestigt sein. Der Kühlkörper weist insbesondere eine Vielzahl von Kühlrippen auf.

Erfindungsgemäß umfasst die Leistungselektronik einen Radiallüfter zur Einleitung eines Luftstroms in den Kühlkörper. Während Axiallüfter die Luft axial ansaugen und auch axial ausstoßen, saugen Radiallüfter die Luft zwar ebenfalls axial an, stoßen diese jedoch radial wieder aus. Der Radiallüfter ist insbesondere dazu ausgebildet, in einer axialen Richtung Luft von außerhalb der Leistungselektronik anzusaugen. Anschließend an den Radiallüfter ist dabei erfindungsgemäß ein Umlenkelement derart angeordnet, dass zumindest ein Teil des von dem Radiallüfter radial ausgestoßenen Luftstroms in die axiale Richtung in den Kühlkörper hinein umgelenkt wird. Das Umlenkelement, welches insbesondere durch ein Umlenkblech gebildet sein kann, kann folglich den radial aus dem Radiallüfter austretenden Luftstrom um insbesondere 90° ablenken, nämlich zurück in die axiale Richtung. Somit ist letztlich die Leistungselektronik, insbesondere durch das Zusammenwirken von Radiallüfter und Umlenkblech, dazu ausgebildet, in der axialen Richtung Luft anzusaugen, diese zumindest teilweise, insbesondere senkrecht zu der axialen Richtung, radial weiterzuführen und wieder entlang der axialen Richtung in den Kühlkörper hinein zu lenken. Insbesondere kann der Radiallüfter ein Gehäuse mit einer zu dem Umlenkelement hin gerichteten Öffnung aufweisen. Das Umlenkelement kann bevorzugt aus Metall oder Kunststoff bestehen. Erfindungsgemäß umfasst der Kühlkörper eine Vielzahl von sich entlang der axialen Richtung erstreckenden Rippen. Durch derart angeordnete Kühlrippen wird eine besonders gute Kühlleistung erreicht, da der durch das Umlenkelement auf die axiale Richtung zurückgelenkte Luftstrom parallel an den Kühlrippen entlangläuft. Dank des Umlenkelements kann der Radiallüfter seitlich zu dem Kühlkörper und der Leiterplatte angeordnet und der Kühlkörper mit einer wesentlich geringeren Bauhöhe ausgestaltet werden. Der Radiallüfter ist also insbesondere seitlich zu dem Kühlkörper und der Leiterplatte angeordnet. Seitlich angeordnet bedeutet dabei insbesondere, dass eine entlang der axialen Richtung verlaufende Rotationsachse des Radiallüfters parallel zu einer Oberseite des Kühlkörpers und/oder der Leiterplatte verläuft. Wie eingangs erwähnt, lässt sich mit einem Axiallüfter bei einer solchen seitlichen Anordnung eine ausreichende und effiziente Kühlung nur dann erreichen, wenn der Kühlkörper mindestens so hoch baut wie der Lüfter, da ansonsten ein Teil des durch den Axiallüfter bereitgestellten Luftstroms nicht durch den Kühlkörper sondern an diesem vorbei strömen würde. Bei bekannten Axiallüftern beträgt die Höhe meist 40 mm bis 60 mm. Die Bauhöhe der Anordnung aus Kühlkörper und Leiterplatte mitsamt Leistungsbauteilen kann somit, bei einer Höhe von Leiterplatte mitsamt Leistungsbauteilen von 60 mm, 100 mm bis 120 mm betragen. Mit dem beschriebenen Konzept aus Radiallüfter und Umlenkblech wird die eingangs genannte Kopplung von Durchmesser des Lüfters und Kühlkörperhöhe aufgehoben. Der Kühlkörper kann somit bei der erfindungsgemäßen Leistungselektronik eine wesentlich geringere Bauhöhe von beispielsweise nur 15 mm aufweisen. Der Radiallüfter kann nichtsdestotrotz erheblich größer ausgebildet sein, z.B. eine Bauhöhe von 60 mm aufweisen, um einen ausreichend großen Luftvolumenstrom durch den Kühlkörper und damit eine ausreichende Kühlleistung zu erreichen. Dank der Umlenkung des Luftstroms durch das Umlenkelement wird der Luftstrom also trotzdem effektiv in den Kühlkörper, insbesondere durch Zwischenräume zwischen Kühlrippen des Kühlkörpers gelenkt. Durch diese Anordnung wirkt der Radiallüfter letztlich wie ein Axiallüfter, der Kühlkörper kann aber wesentlich kompakter bauen.

Nach einer Ausgestaltung verläuft eine entlang der axialen Richtung verlaufende Rotationsachse des Radiallüfters parallel zu einer Oberseite des Kühlkörpers und/oder der Leiterplatte. Wie bereits erwähnt, kann hierdurch die Anordnung des Radiallüfters seitlich zum Kühlkörper und/oder der Leiterplatte erreicht werden. Die Oberseite des Kühlkörpers ist dabei insbesondere die Leiterplatte zugewandte Seite. Somit bedeutet die seitliche Anordnung, dass der Radiallüfter nicht flächig auf dem Kühlkörper, beispielsweise auf einer der Oberseite gegenüberliegenden Unterseite, aufliegt, sondern stattdessen senkrecht zu dem Kühlkörper stehend angeordnet ist. Hierdurch kann der Kühlkörper, wie erläutert, mit geringer Bauhöhe realisiert werden, da dank des Umlenkelements der Luftstrom vom Radiallüfter in den Kühlkörper geleitet wird.

Nach einer Ausgestaltung beträgt die Höhe des Kühlkörpers ein Viertel oder weniger der Höhe der Leiterplatte mit den Leistungshalbeitern. Insbesondere beträgt die Höhe des Kühlkörpers 15 mm oder weniger. Der Aufbau aus der Leiterplatte mitsamt Leistungshalbeitern und dem Kühlkörper weist insbesondere eine Höhe von 75 mm oder weniger auf. Diese sehr geringen Bauhöhen werden, wie erwähnt, durch die erfindungsgemäße Anordnung aus Radiallüfter und Umlenkblech ermöglicht. Liegt die Bauhöhe von Leiterplatte mitsamt Leistungshalbeitern bei den erwähnten 60 mm, ergibt sich das genannte Höhenverhältnis von 1 zu 4. Gegenüber der bekannten Leistungselektronik mit seitlichem Axiallüfter ergibt sich somit eine Reduzierung in der Höhe des Aufbaus aus Leiterplatte mit den Leistungshalbeitern und Kühlkörper um 25 % bis 37,5 %.

Nach einer Ausgestaltung weist der Kühlkörper an einer der Leiterplatte zugewandten Oberseite Erhebungen auf, auf denen Wärmeleitpads angeordnet sind, wobei zumindest einige der Leistungshalbleiter mit den Wärmeleitpads in Kontakt stehen. Die Leiterplatte kann insbesondere im Sinne eines top-cooling mit ihrer die Leistungshalbeiter aufweisenden Oberseite der Oberseite des Kühlkörpers zugewandt sein und in Kontakt zu dem Kühlkörper stehen, wie bereits angesprochen. Die Erhebungen können in dem insbesondere aus Aluminium bestehenden Kühlkörper beispielsweise durch Fräsen eingebracht sein. Bei einer Montage der Leiterplatte auf dem Kühlkörper werden die Leistungshalbleiter in die Wärmeleitpads gedrückt, sodass ein geringer Wärmeübergangswiderstand zwischen Leistungshalbleiter und Kühlkörper entsteht.

Nach einer Ausgestaltung sind die Wärmeleitpads zudem dazu ausgebildet, den Kühlkörper von den Leistungshalbleitern elektrisch zu isolieren und/oder die Übertragung von Vibrationen von dem Kühlkörper auf die Leistungshalbleiter zu reduzieren. Die Wärmeleitpads können also neben der Wärmeleitung auch die Funktion einer elektrischen Isolierung zum Kühlkörper erfüllen. Insbesondere können die Wärmeleitpads auch geringe Toleranzen, die beim Auflöten der Leistungshalbleiter auf die Leiterplatte auftreten können, ausgleichen. Zudem können die Pads die Übertragung von Vibrationen von dem Kühlkörper auf die Leistungshalbleiter reduzieren, also insbesondere als Dämpfer wirken. Dies kann insbesondere aufgrund von bei Flurförderzeugen häufig auftretenden starken Erschütterungen wichtig sein.

Nach einer Ausgestaltung umfassen zumindest einige der Leistungshalbleiter GaN-Transistoren. Derartige Gallium-Nitrid-Transistoren sind besonders geeignet, um die hohen Anforderungen an Leistungsdichte und Wirkungsgrad zu erfüllen. Aufgrund der hohen Leistungsdichte kommt es bei GaN-Transistoren jedoch auch zu einer hohen Wärmeentwicklung. Gerade hier ist die erfindungsgemäße Anordnung von Radiallüfter und Umlenkelement von Vorteil, da diese auch die Abfuhr der hohen Wärmemenge bei gleichzeitig geringer Bauhöhe des Kühlkörpers erlaubt.

Nach einer Ausgestaltung weist das Umlenkelement eine im Querschnitt kreisbogenförmige Luftleitwand zum Umleiten des Luftstroms auf. Die Luftleitwand kann so den vom Radiallüfter zu dem Umlenkelement strömenden Luftstrom in die axiale Richtung in den Kühlkörper hinein umlenken. Ist das Umlenkelement als Umlenkblech ausgebildet, kann das Umlenkblech kreisbogenförmig verlaufen. Bevorzugt ist die Luftleitwand bzw. das Umlenkblech im Querschnitt viertelkreisförmig ausgebildet. Insbesondere im Vergleich zu einem schräg gestellten Blech als Umlenkelement ermöglicht dies einen größeren freien Strömungsquerschnitt.

Nach einer Ausgestaltung umfasst die Leistungselektronik mindestens zwei nebeneinander angeordnete Radiallüfter. Die Radiallüfter sind dabei dazu ausgebildet, in einer axialen Richtung Luft anzusaugen und diese radial auszustoßen, wobei ein oder mehrere radial an den jeweiligen Radiallüfter anschließende Umlenkelemente zur Umlenkung zumindest eines Teils des von den Radiallüftern radial ausgestoßenen Luftstroms in die axiale Richtung in den Kühlkörper hinein vorgesehen sind. Die Radiallüfter können beispielsweise jeweils ein solches Umlenkelement aufweisen oder ein gemeinsames. Die Radiallüfter sind insbesondere derart nebeneinander angeordnet, dass sich die jeweils entlang der axialen Richtung parallel zueinander erstreckenden Rotationsachsen der Radiallüfter in derselben Höhe über dem Kühlkörper und/oder der Leiterplatte befinden. Das Vorsehen mehrerer Radiallüfter nebeneinander kann bei großen Leiterplatten hilfreich sein, da so bei ausreichend großer Kühlleistung die Anordnung nicht zu hoch baut.

Nach einer Ausgestaltung umfasst die Leistungselektronik ein den Radiallüfter radial umschließendes Lüftergehäuse mit einer zu dem Umlenkelement hin gerichteten Öffnung auf, wie bereits erwähnt. Somit kann auch die nicht direkt radial zu dem Umlenkblech gerichtete Luft über Gehäuseinnenwände des Lüftergehäuses zu dem Umlenkblech geführt und damit axial in den Kühlkörper hinein gerichtet werden. Das Gehäuse kann den Radiallüfter nach einer Ausgestaltung bis auf die zu dem Umlenkelement hin gerichtete Öffnung insbesondere vollständig radial umschließen. Somit kann im Wesentlichen (ggf. abgesehen von fertigungsbedingten oder prozessbedingten Verlusten) der gesamte von dem Radiallüfter radial ausgestoßenen Luftstrom in die axiale Richtung in den Kühlkörper hinein gelenkt werden. Dies erhöht den Volumenstrom und somit die Kühlleistung. Sind mehrere Radiallüfter nebeneinander vorgesehen, kann insbesondere ein alle Radiallüfter gemeinsam radial umschließendes Gehäuse vorgesehen sein.

Die Erfindung betrifft zudem ein Einbauladegerät mit einer erfindungsgemäßen Leistungselektronik.

Eine Ausgestaltung der Erfindung wird im Folgenden anhand von Figuren erläutert. Es zeigen schematisch:
- Figur 1: eine erfindungsgemäße Leistungselektronik in einer Seitenansicht,
- Figur 2: die Leistungselektronik aus Figur 1 mit Blick in axialer Richtung auf den Radiallüfter,
- Figur 3: eine erfindungsgemäße Leistungselektronik in einer Ausgestaltung mit zwei Radiallüftern.

Soweit nichts anderes angegeben ist, bezeichnen im Folgenden gleiche Bezugszeichen gleiche Gegenstände

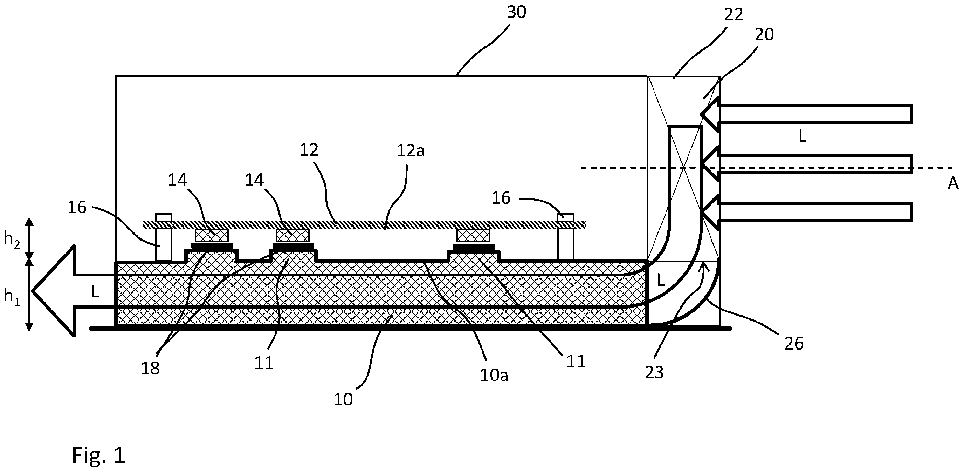

In Figur 1 ist eine erfindungsgemäße Leistungselektronik in einer Seitenansicht grob schematisch dargestellt. Die Leistungselektronik umfasst einen Kühlkörper 10 und eine auf dem Kühlkörper 10 angeordnete Leiterplatte 12. Die Leiterplatte 12 weist Leistungshalbleiter 14 auf, die auf die Leiterplatte 12 gelötet sind. Die Leistungshalbleiter können insbesondere Gallium-Nitrid-Transistoren sein. Über Abstandshalter 16 und durch die Abstandshalter 16 verlaufende, nicht ersichtliche Schrauben ist die Leiterplatte 12 an dem Kühlkörper 10 befestigt. Die Leiterplatte 12 ist mit einer Oberseite 12a, an welcher die Leistungshalbleiter 14 angeordnet sind, einer Oberseite 10a des Kühlkörpers 10 zugewandt. Von der Oberseite 10a erstrecken sich in Richtung der gegenüberliegenden Leiterplatte 12 Erhebungen 11 von dem Kühlkörper 10 fort. Diese Erhebungen 11 sind in dem insbesondere aus Aluminium gefertigten Kühlkörper 10 durch Fräsen ausgebildet. Auf den Erhebungen 11 sind wiederum Wärmeleitpads 18 angeordnet, über welche der Kühlkörper 10 mit den Leistungshalbleitern 14 in Verbindung steht. Die Wärmeleitpads 18 weisen eine hohe Wärmeleitfähigkeit auf und führen die im Betrieb durch die Leistungshalbleiter 14 abgegebene Wärme in den Kühlkörper 10 ein. Zudem können die Wärmeleitpads auch geringe Toleranzen, die beim Auflöten der Leistungshalbleiter auf die Leiterplatte auftreten können, ausgleichen und zudem für eine mechanische Entkoppelung zwischen Kühlkörper und Leistungshalbleitern sorgen. Weiterhin kann auch eine elektrische Isolation zwischen Kühlkörper und Leistungshalbleitern durch die Wärmeleitpads erreicht werden.

Seitlich zu dem Kühlkörper 10 und der Leiterplatte 12 ist ein Radiallüfter 20 angeordnet. Der Radiallüfter 20 umfasst ein Lüftergehäuse 22, in welchem ein Laufrad 24 mit mehreren Lamellen um eine Rotationsachse A drehbar gelagert ist. Der Radiallüfter 20 ist dazu ausgebildet, in einer parallel zu der Rotationsachse A verlaufenden axialen Richtung Luft anzusaugen und diese in einer senkrecht zu der Rotationsachse A stehenden radialen Richtung auszustoßen. An den Radiallüfter 20 schließt unten ein Umlenkelement 26 an, welches die radial nach unten aus dem Radiallüfter 20 austretende Luft wiederum in die axiale Richtung parallel zu der Rotationsachse A ablenkt und in den Kühlkörper 10 hinein führt. Der somit erfolgende Luftstrom L durch den Radiallüfter und den Kühlkörper ist durch Pfeile verdeutlicht.

Das Umlenkelement 26, welches insbesondere durch ein gebogenes Blech gebildet sein kann, ermöglicht in Kombination mit dem Radiallüfter 20 einen kompakten Aufbau der Leistungselektronik bei gleichzeitig ausreichend guter Kühlleistung. Wie insbesondere in Figur 1 ersichtlich, erstreckt sich die Rotationsachse A und damit die axiale Richtung parallel zu Oberfläche 10a des Kühlkörpers 10 sowie parallel zu Oberfläche 12a der Leiterplatte 12. In diesem Sinne ist der Radiallüfter 20 seitlich zu dem Kühlkörper 10 und seitlich zu der Leiterplatte 12 angeordnet. Durch die erfindungsgemäße Anordnung von Radiallüfter und Umlenkblech kann der Kühlkörper mit einer besonders niedrigen Bauhöhe h₁ realisiert werden. Insbesondere ist es nicht länger notwendig, dass der Kühlkörper dieselbe Höhe aufweist wie der Lüfter. Der Kühlkörper 10 kann insbesondere eine Höhe h₁ von 15 mm oder weniger aufweist. Sollte der Aufbau aus Leiterplatte und Leistungsbauteilen beispielsweise eine Höhe h₂ von 60 mm aufweisen, ergibt sich für den gesamten Aufbau aus Kühlkörper und Leiterplatte mitsamt Leistungsbauteilen lediglich eine Gesamthöhe von 75 mm oder weniger. Die Höhe des Kühlkörpers liegt damit insbesondere nur bei einem Viertel oder weniger der Höhe der Leiterplatte mitsamt Leistungsbauteilen. Der Aufbau ist damit gegenüber einer bekannten Leistungselektronik mit seitlich zum Kühlkörper bzw. zur Leiterplatte angeordnetem Axiallüfter um 25 bis 37,5 % verkleinert. Die gesamte Leistungselektronik kann mitsamt Radiallüfter und Umlenkblech in einem Gehäuse 30 angeordnet sein.

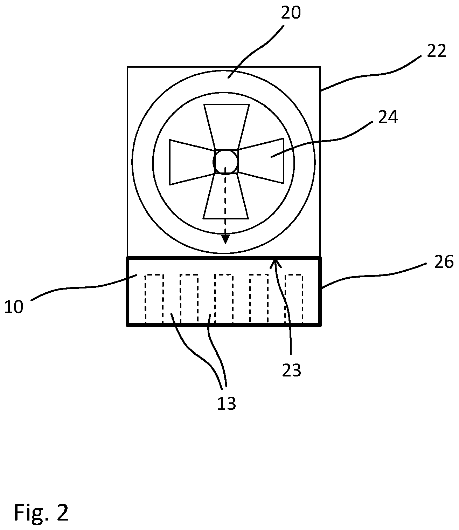

In Figur 2 ist die Leistungselektronik mit Blick in der axialen Richtung dargestellt. Die Rotationsachse A erstreckt sich hier also in die Bildebene hinein. Insbesondere ist hier das den Radiallüfter 20 nach außen begrenzende Lüftergehäuse 22 erkennbar. Das Lüftergehäuse 22 ist insbesondere derart ausgestaltet, dass der Radiallüfter 20 die in axialer Richtung angesaugt Luft nicht um einen Winkel von 360° radial ausstößt sondern lediglich in Figur 2 nach unten zu dem Umlenkblech 26 hin. Das Umlenkblech 26 ist in Figur 2 durchsichtig dargestellt, um einen Blick auf den Kühlkörper 10 zu ermöglichen, wobei hier sich parallel zu der axialen Richtung erstreckende Kühlrippen 13 des Kühlkörpers 10 ersichtlich sind. Die über das Umlenkblech 26 in den Kühlkörper 10 umgelenkt Luftströmung fließt entlang der Kühlrippen 13 und sorgt somit für eine effektive Kühlung.

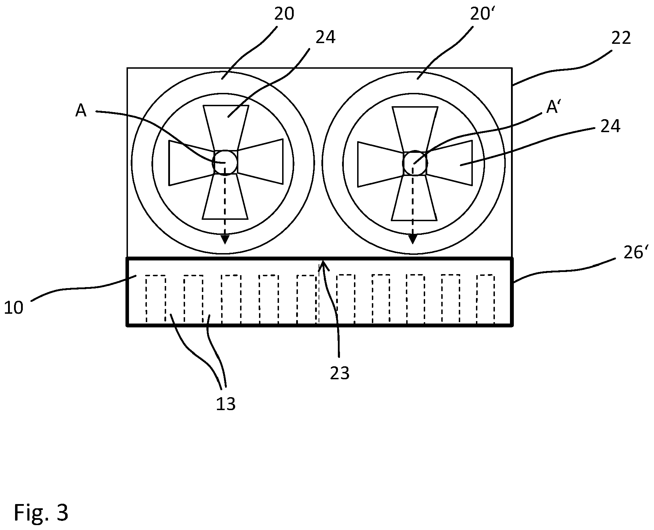

Figur 3 zeigt eine erfindungsgemäße Leistungselektronik in einer Ausgestaltung mit zwei Radiallüftern 20, 20`.Der Blick auf die Leistungselektronik ist hierbei derselbe wie in Figur 2, also in der axialen Richtung. Die Radiallüfter 20, 20' sind gemeinsam in dem Lüftergehäuse 22 angeordnet und insbesondere identisch aufgebaut. Das Umlenkblech 26` erstreckt sich hierbei über die Breite beider Radiallüfter 20, 20' und lenkt die radial durch die Radiallüfter 20, 20' in Figur 3 nach unten ausgestoßene Luft wieder in die axiale Richtung. Es gilt das zu dem vorherigen Ausführungsbeispiel Erläuterte. Die Radiallüfter 20, 20' sind hierbei derart nebeneinander angeordnet, dass sich die jeweils entlang der axialen Richtung parallel zueinander erstreckenden Rotationsachsen A, A` (in Figur 3 in senkrecht zur Bildebene) der Radiallüfter 20, 20' in derselben Höhe über dem Kühlkörper 10 und/oder der Leiterplatte 12 befinden. Das Vorsehen mehrerer Radiallüfter nebeneinander kann bei großen Leiterplatten hilfreich sein, da so bei ausreichend großer Kühlleistung die Anordnung nicht zu hoch baut.

## Patentansprüche

1. Leistungselektronik für ein Flurförderzeug, insbesondere für ein Einbauladegerät des Flurförderzeugs, umfassend einen Kühlkörper (10) und eine auf dem Kühlkörper (10) angeordnete Leiterplatte (12) mit Leistungshalbeitern (14), wobei
• ein Radiallüfter (20) zur aktiven Kühlung des Kühlkörpers (10) vorgesehen ist, der dazu ausgebildet ist, in einer axialen Richtung Luft anzusaugen und diese radial auszustoßen, wobei die axiale Richtung entlang der Rotationsachse (A) des Radiallüfters (20) verläuft und
• ein radial an den Radiallüfter (20) anschließendes Umlenkelement (26) zur Umlenkung zumindest eines Teils des von dem Radiallüfter (20) radial ausgestoßenen Luftstroms in die axiale Richtung in den Kühlkörper (10) hinein vorgesehen sind, wobei
• der Kühlkörper (10) eine Vielzahl von sich entlang der axialen Richtung erstreckenden Kühlrippen (13) umfasst.

2. Leistungselektronik nach Anspruch 1, **dadurch gekennzeichnet, dass** die Rotationsachse (A) parallel zu einer Oberfläche (10a, 12a) des Kühlkörpers (10) und/oder der Leiterplatte (12) verläuft.

3. Leistungselektronik nach Anspruch 1 oder 2, **dadurch gekennzeichnet, dass** die Höhe des Kühlkörpers (10) ein Viertel oder weniger der Höhe der Leiterplatte mit den Leistungshalbeitern beträgt.

4. Leistungselektronik nach einem der vorhergehenden Ansprüche, **dadurch gekennzeichnet, dass** der Kühlkörper (10) eine Höhe von 15 mm oder weniger aufweist.

5. Leistungselektronik nach einem der vorhergehenden Ansprüche, **dadurch gekennzeichnet, dass** der Aufbau aus Leiterplatte (12) mit Leistungshalbeitern (14) und Kühlkörper (10) eine Höhe von 75 mm oder weniger aufweist.

6. Leistungselektronik nach einem der vorhergehenden Ansprüche, **dadurch gekennzeichnet, dass** der Kühlkörper (10) an einer der Leiterplatte (12) zugewandten Oberseite (10a) Erhebungen (11) aufweist, auf denen Wärmeleitpads (18) angeordnet sind, wobei zumindest einige der Leistungshalbleiter (14) mit den Wärmeleitpads (18) in Kontakt stehen.

7. Leistungselektronik nach Anspruch 6, **dadurch gekennzeichnet, dass** die Wärmeleitpads (18) dazu ausgebildet sind, den Kühlkörper (10) elektrisch zu isolieren und/oder die Übertragung von Vibrationen von dem Kühlkörper (10) auf die Leistungshalbleiter (14) zu reduzieren.

8. Leistungselektronik nach einem der vorhergehenden Ansprüche, **dadurch gekennzeichnet, dass** zumindest einige der Leistungshalbleiter GaN-Transistoren umfassen.

9. Leistungselektronik nach einem der vorhergehenden Ansprüche, **dadurch gekennzeichnet, dass** das Umlenkelement (26) kreisbogenförmig ausgebildet ist.

10. Leistungselektronik nach einem der vorhergehenden Ansprüche, **dadurch gekennzeichnet, dass** mindestens zwei nebeneinander angeordnete Radiallüfter (20, 20`) vorgesehen sind.

11. Leistungselektronik nach einem der vorhergehenden Ansprüche, **gekennzeichnet durch** ein den Radiallüfter (20) radial umschließendes Lüftergehäuse (22) mit einer zu dem Umlenkelement (26) hin gerichteten Öffnung (23).

12. Leistungselektronik nach Anspruch 11, **dadurch gekennzeichnet, dass** das Lüftergehäuse (22) den Radiallüfter (20) bis auf die zu dem Umlenkelement (26) hin gerichtete Öffnung (23) vollständig radial umschließt.

13. Einbauladegerät mit einer Leistungselektronik nach einem der vorhergehenden Ansprüche.

## Claims

1. Power electronics for an industrial truck, in particular for an on-board charger of the industrial truck, comprising a heat sink (10) and a circuit board (12) with power semiconductors (14) arranged on the heat sink (10), wherein
• a centrifugal fan (20) is provided for actively cooling the heat sink (10), which centrifugal fan is designed to draw in air in an axial direction and to expel same radially, wherein the axial direction extends along the axis of rotation (A) of the centrifugal fan (20) and
• a diverting element (26) connected radially to the centrifugal fan (20) are provided for diverting at least some of the air flow expelled radially by the centrifugal fan (20) in the axial direction into the heat sink (10), wherein
• the heat sink (10) comprises a plurality of cooling fins (13) extending in the axial direction.

2. The power electronics according to claim 1, **characterized in that** the axis of rotation (A) extends in parallel with a surface (10a, 12a) of the heat sink (10) and/or circuit board (12).

3. The power electronics according to claim 1 or 2, **characterized in that** the height of the heat sink (10) is one quarter or less of the height of the circuit board with the power semiconductors.

4. The power electronics according to any one of the preceding claims, **characterized in that** the heat sink (10) has a height of 15 mm or less.

5. The power electronics according to any one of the preceding claims, **characterized in that** the structure consisting of the circuit board (12) with power semiconductors (14) and the heat sink (10) has a height of 75 mm or less.

6. The power electronics according to any one of the preceding claims, **characterized in that** the heat sink (10), on the top side (10a) facing the circuit board (12), comprises elevations (11) on which thermal pads (18) are arranged, wherein at least some of the power semiconductors (14) are in contact with the thermal pads (18).

7. The power electronics according to claim 6, **characterized in that** the thermal pads (18) are designed to electrically insulate the heat sink (10) and/or to reduce the transmission of vibrations from the heat sink (10) to the power semiconductors (14).

8. The power electronics according to any one of the preceding claims, **characterized in that** at least some of the power semiconductors comprise GaN transistors.

9. The power electronics according to any one of the preceding claims, **characterized in that** the diverting element (26) is in the shape of a circular arc.

10. The power electronics according to any one of the preceding claims, **characterized in that** at least two centrifugal fans (20, 20') arranged one next to the other are provided.

11. The power electronics according to any one of the preceding claims, **characterized by** a fan housing (22) radially surrounding the centrifugal fan (20) and having an opening (23) directed toward the diverting element (26).

12. The power electronics according to claim 11, **characterized in that** the fan housing (22) completely radially surrounds the centrifugal fan (20) except for the opening (23) directed toward the diverting element (26).

13. An on-board charger comprising power electronics according to any one of the preceding claims.

## Revendications

1. Électronique de puissance pour un chariot de manutention, en particulier pour un chargeur de montage du chariot de manutention, comportant un corps de refroidissement (10) et un circuit imprimé (12) disposé sur le corps de refroidissement (10) avec des semiconducteurs de puissance (14), dans laquelle
• il est prévu un ventilateur radial (20) pour le refroidissement actif du corps de refroidissement (10), lequel est conçu pour aspirer de l'air dans une direction axiale et souffler celui-ci radialement, dans laquelle la direction axiale s'étend le long de l'axe de rotation (A) du ventilateur radial (20) et
• un élément de déviation (26) relié radialement au ventilateur radial (20) pour la déviation d'une partie au moins du flux d'air soufflé radialement par le ventilateur radial (20) dans la direction axiale vers l'intérieur du corps de refroidissement (10),
dans lequel
• le corps de refroidissement (10) comporte une pluralité de nervures de refroidissement (13) s'étendant le long de la direction axiale.

2. Électronique de puissance selon la revendication 1, **caractérisée en ce que** l'axe de rotation (A) s'étend parallèlement à une surface (10a, 12a) du corps de refroidissement (10) et/ou du circuit imprimé (12).

3. Électronique de puissance selon la revendication 1 ou 2, **caractérisée en ce que** la hauteur du corps de refroidissement (10) mesure un quart ou moins de la hauteur du circuit imprimé avec les semiconducteurs de puissance.

4. Électronique de puissance selon l'une des revendications précédentes, **caractérisée en ce que** le corps de refroidissement (10) présente une hauteur de 15 mm ou moins.

5. Électronique de puissance selon l'une des revendications précédentes, **caractérisée en ce que** la structure constituée du circuit imprimé (12) avec les semiconducteurs de puissance (14) et du corps de refroidissement (10) présente une hauteur de 75 mm ou moins.

6. Électronique de puissance selon l'une des revendications précédentes, **caractérisée en ce que** sur un côté supérieur (10a) tourné vers le circuit imprimé (12), le corps de refroidissement (10) présente des surélévations (11) sur lesquelles sont disposés des coussins thermiques (18), dans laquelle au moins quelques-uns des semiconducteurs de puissance (14) sont en contact avec les coussins thermiques (18).

7. Électronique de puissance selon la revendication 6, **caractérisée en ce que** les coussins thermiques (18) sont conçus pour isoler électriquement le corps de refroidissement (10) et/ou pour réduire la transmission de vibrations du corps de refroidissement (10) aux semiconducteurs de puissance (14).

8. Électronique de puissance selon l'une des revendications précédentes, **caractérisée en ce que** quelques-uns au moins des semiconducteurs de puissance comportent des transistors GaN.

9. Électronique de puissance selon l'une des revendications précédentes, **caractérisée en ce que** l'élément de déviation (26) est réalisé en forme d'arc de cercle.

10. Électronique de puissance selon l'une des revendications précédentes, **caractérisée en ce qu'**il est prévu au moins deux ventilateurs radiaux (20, 20') disposés l'un à côté de l'autre.

11. Électronique de puissance selon l'une des revendications précédentes, **caractérisée par** un boîtier de ventilateur (22) entourant radialement le ventilateur radial (20), avec une ouverture (23) orientée vers l'élément de déviation (26).

12. Électronique de puissance selon la revendication 11, **caractérisée en ce que** le boîtier de ventilateur (22) entoure complètement radialement le ventilateur radial (20) à l'exception de l'ouverture (23) orientée vers l'élément de déviation (26).

13. Chargeur de montage comprenant une électronique de puissance selon l'une des revendications précédentes.
